# EUROPÄISCHE PATENTSCHRIFT

(11) **EP 2 401 897 B1**
(45) Veröffentlichungstag und Bekanntmachung des Hinweises auf die Patenterteilung: **12.02.2014**
(21) Anmeldenummer: 10707860.2
(22) Anmeldetag: 23.02.2010
(51) Int. Cl.: H05K 1/16, H05K 3/46

(54) **MEHRLAGIGER SCHALTUNGSTRÄGER UND VERFAHREN ZU DESSEN HERSTELLUNG**
MULTI-LAYER CIRCUIT CARRIER AND METHOD FOR THE PRODUCTION THEREOF
SUPPORT DE CIRCUIT MULTICOUCHE ET SON PROCÉDÉ DE FABRICATION

(30) Priorität: 27.02.2009 DE 102009010874
(43) Veröffentlichungstag der Anmeldung: 04.01.2012
(73) Patentinhaber: Siemens Aktiengesellschaft, 80333 München (DE)
(72) Erfinder: GÖTSCH, Dieter, 85521 Ottobrunn (DE); KARMAZIN, Roman, 80939 München (DE); MATZ, Richard, 83052 Bruckmühl (DE)
(86) Internationale Anmeldenummer: PCT/EP2010/052286
(87) Internationale Veröffentlichungsnummer: WO 2010/097387

(56) Entgegenhaltungen:
- JP-A- 3 278 594
- JP-A- 2007 266 114
- JP-A- 2008 258 553
- US-A- 6 021 050

## Beschreibung

Die Erfindung betrifft mehrlagige Schaltungsträger, wie beispielsweise kupferkaschierte, organische Faserverbundfolien oder Low Temperature Cofired Ceramics/LTCC (bei niederer Temperatur gesinterte Keramik).

Derartige Schaltungsträger ermöglichen auf Grund ihrer guten Leiterbahn-Qualität die Einbettung von Spulen zur Darstellung von Induktivitäten und Transformatoren, beispielsweise in leistungselektronischen Schaltungen. Zur Erzielung hoher Induktivitätswerte an einzelnen Spulen bzw. zur Erzielung guter magnetischer Kopplungen in den Transformatoren werden in der Regel zusätzliche Elemente aus magnetischer Keramik, bezeichnet als Ferrit, benötigt. Hintergrund ist die Verstärkung des Magnetfeldes und/oder dessen Ausformung.

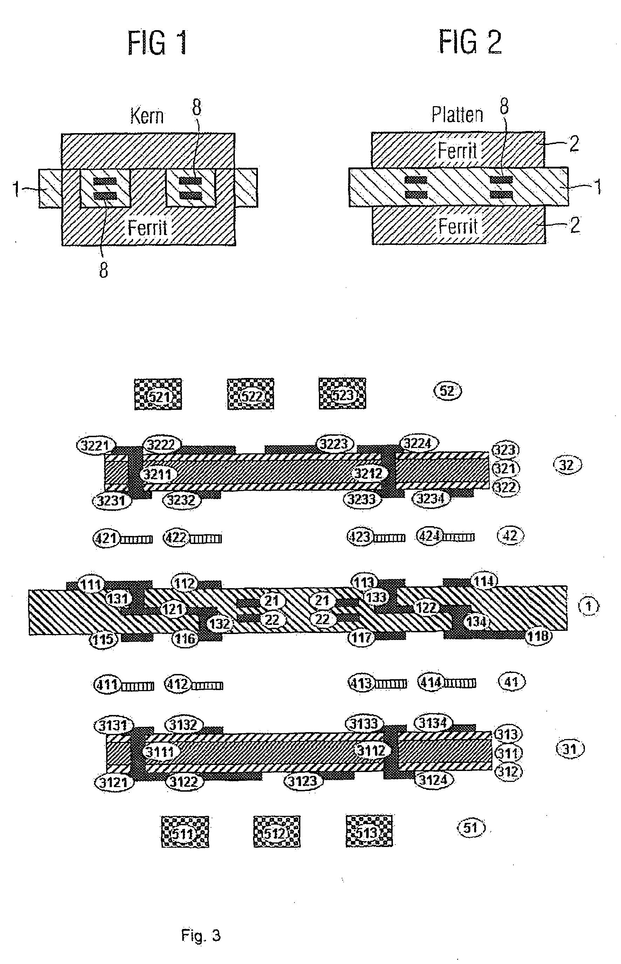

Die bekannten und häufig eingesetzten Strukturen derartiger Ferrit-Elemente sind in den Fig. 1 und 2 dargestellt. Mittels einer Kernstruktur entsprechend Fig. 1 lassen sich hohe Induktivitäten erzielen. Dabei erstreckt sich der magnetische Fluss entlang der gemeinsamen Achse von Primär- und Sekundärspule eines Transformators und wird durch das Ferritmaterial verstärkt. Eine Öffnung in dem mehrlagigen Schaltungsträger, insbesondere einer Platine, wird mit einem Ferritkern bestückt, der so gestaltet ist, dass sich der eingeschlossene Fluss oberhalb und unterhalb der Platine durch zwei seitwärts/waagerecht verlaufende Schenkel und zwei äußere vertikale Ferritsäulen schließen kann. Auf diese Weise entsteht ein Ferrit-Element in Form einer Acht, welches beim Aufsetzen auf die Platine aus einem E-förmigen und einem I-förmigen Teil zusammengesetzt ist und mit Klammern zusammengehalten wird.

Eine einfachere Struktur, bestehend aus zwei getrennten Ferritplatten entsprechend Fig. 2, ergibt sich, wenn die vertikalen, die Platine durchdringenden, Ferritsegmente entfallen. Dies führt zwar zu einer Verminderung der Induktivitäten entsprechend der Ausführung eines Transformators nach Fig. 1, und führt zu eingeschränkter Leistung im unteren Frequenzbereich, lässt sich jedoch einfacher herstellen.

Nachteilig ist, dass Ferrit-Elemente relativ große Flächenanteile des als Basis dienenden Schaltungsträgers belegen. Dies steht insbesondere einer Miniaturisierung entgegen. Die dadurch belegte Fläche ist in der Regel für eine Bestückung mit SMD-Bauelementen/oberflächlich montierbaren Bauelementen ungeeignet.

Im Stand der Technik ist bisher kein Konzept bekannt, welches eine umfassende Lösung wiedergibt. Ferritkerne werden üblicherweise relativ schmal ausgelegt, um den Flächenbedarf zu reduzieren. Andererseits muss der für den Fluss erforderliche Querschnitt bei schmaler Auslegung der Ferritkerne durch entsprechende Bauhöhe erzielt werden. Auf dem Markt sind unterschiedlichste Formen und Größen von Ferritkernen erhältlich.

In der Literaturstelle [1] wird beispielsweise ein mehrlagiger Transformator betrachtet, der Mn-Zn Ferrite aufweist. Es werden die elektrischen Merkmale beschrieben und zwei Typen von Transformatoren verglichen, welche zum Einen eine konventionelle Windungsstruktur und zum Anderen eine neue Windungsstruktur aufweisen, wobei primärer- und sekundärer Leiter alternierend nicht lediglich in der vertikalen Richtung, sondern ebenso in der horizontalen Richtung positioniert sind. Durch derartige Varianten können die Kopplungskoeffizienten optimiert werden.

Weiterhin ist aus der Literaturstelle [2] ein planarer Transformator zur Integration an Leiterplatten bekannt. Ein entsprechender Wandler kann eine Vielzahl von Verbrauchern versorgen. Die planare Vorrichtung besteht aus Spiralwindungen an integrierten Schaltungen und Ferritpolymerplatten, beispielsweise mit magnetischem Kern.

Beide oben genannten Literaturstellen geben keine Auskunft zur optimalen Ausnutzung hinsichtlich einer Bestückung mit SMD-Bauelementen.

Der Erfindung liegt die Aufgabe zugrunde, eine Bauform und ein entsprechendes Herstellungsverfahren für planare Induktivitäten und Transformatoren derart anzugeben, dass sich diese Bauelemente bei ihrer Integration in mehrlagige Schaltungsträger so einbetten lassen, dass sie sich wie eine konventionelle Platine oberflächlich weiter bestücken lassen und somit ihr Flächenbedarf vernachlässigbar wird.

Die Lösung dieser Aufgabe wird wiedergegeben durch die jeweilige Merkmalskombination eines Hauptanspruchs. Vorteilhafte Ausgestaltungen können den Unteransprüchen entnommen werden.

Der Erfindung liegt die Erkenntnis zugrunde, dass die Ferritplatten von planaren Transformatoren oder Induktivitäten bei niedrigen Sintertemperaturen hergestellt und dadurch im CoFiring-Verfahren mit vertikalen metallischen Durchkontaktierungen und oberflächlichen dielektrischen keramischen Isolationsschichten versehen werden können. Nach der erfindungsgemäßen Bauform übernehmen die Ferritplatten die Doppelfunktion als Leiter des magnetischen Flusses und als Schaltungsträger weiterer oberflächenmontierter Bauteile (surface mounted devices SMD). Dadurch wird ein wesentlicher Miniaturisierungsfortschritt erzielt.

Der Aufbau einer entsprechenden mehrlagigen Schaltungsanordnung sieht vor, dass die zur Fluss-Formung und Verstärkung vorhandenen Ferritplatten auf einem dielektrischen Schaltungsträger (Hauptplatine) im Bereich einer integrierten planaren Spule oder eines planaren Transformators weiterhin vorhanden sind. In Abwandlung zum Stand der Technik sind die Ferritplatten durch ein Sinterverfahren aus mehreren einzelnen Lagen hergestellt, bestehend vorzugsweise aus niedrig sinternder LTCC-Keramik (Low Temperature Cofiring Ceramics), die vor dem Sintern im "grünen" Zustand metallisch bedruckt und zu einem Schichtverbund laminiert werden. Wesentlich ist, dass die Ferritschichten bei diesem Verfahren mit metallischen Durchkontaktierungen und mit dielektrischen, hoch isolierenden Deckschichten versehen werden. Im Anschluss werden die so hergestellten Ferritplatten durch Löt- oder Klebeverfahren auf einem dielektrischen Schaltungsträger im Bereich einer Spule oder eines Transformators beidseitig befestigt. Die dielektrischen Isolatorschichten und die Leiterbahnen mit Durchkontaktierungen eröffnen die Möglichkeit einer Bestückung mit SMD-Bauelementen auch auf der Oberfläche der Ferritplatten, so dass diese mit Hilfe der Verbindungstechnik der Ferritplatten elektrisch mit den Schaltkreiselementen der Hauptplatine verbunden sind.

Die Lagen von ein- oder mehrlagigen dielektrischen Schaltungsträgern können vorteilhaft aus organischen oder keramischen Materialien oder aus Verbundmaterial dargestellt werden. Die Befestigung der fertig vorbereiteten Ferritplatten an der Oberfläche des dielektrischen Schaltungsträgers kann vorzugsweise in Form einer Klebung mit einem Epoxid-Kleber geschehen oder in Form einer Lötung, beispielsweise unter Verwendung von Hartlot oder nanotechnologischem Silberlot.

Nachdem durch die Erfindung die Oberfläche der Ferritplatten für eine SMD-Bestückung nutzbar gemacht ist, können derartige Bauteile aus anderen Teilen der Gesamtschaltung dort platziert werden, so dass ein kompakterer Aufbau erzielt wird.

In alternativen Ausführungsformen zu den Durchkontaktierungen aus der Platine heraus kann die elektrische Kontaktierung der SMD auch ganz oder teilweise durch eine Kontaktierung von oben ersetzt werden. Nach dem Stand der Technik kann das beispielsweise durch Bonddrähte oder durch das SIPLIT-Verfahren (Siemens Planar Interconnect Technology) geleistet werden, bei dem die SMD mit einer photostrukturierbaren Folie als Träger galvanisch abgeschiedener Metallisierung überdeckt werden.

Ein Verfahren zur Herstellung einer mehrlagigen Schaltungsanordnung entsprechend der Erfindung beruht auf der Erkenntnis, dass die Ferritplatten mit Isolierschichten durch Sinterverfahren oberflächlich isoliert werden können, wobei sogenannte LTCC-Keramik eingesetzt wird. Dies kann insbesondere MnZn-Ferrit oder NiZnCu-Ferrit sein. Diese Ferritwerkstoffe können so angepasst werden, dass sie im typischen Frequenzbereich von flachen Planartransformatoren, d.h. bei 1 bis 5 MHz, ausreichende relative Permeabilität von über 400 besitzen. Die Ferritplatten können ein- oder mehrlagig ausgebildet sein. Wesentlich ist die externe Darstellung der Ferritplatten mit beidseitig aufgesinterten Isolatorschichten, insbesondere mittels dielektrischer Keramiklagen. Gleichzeitig werden einbrennbare vertikale Durchkontaktierungen und Oberflächenmetallisierungen aufgebracht, sodass die gesamte Oberfläche für die Montage von Bauelementen vorbereitet ist. Typischerweise besteht der mittlere Schaltungsträger aus zehn bis 20 dielektrischen Keramikschichten zu je 50 bis 100µm Schichtdicke. Die Ferritplatten werden beispielsweise aus 50 bis 100µm dicken Einzellagen zu einer Gesamtdicke von 100 bis 500µm aufgebaut. Ihre laterale Ausdehnung reicht mit 10 bis 20mm über die Fläche der eingebetteten Spulenwindungen der Induktivität oder des Transformators hinaus.

Im Folgenden werden anhand von begleitenden schematischen, die Erfindung nicht einschränkenden Figuren Ausführungsbeispiele beschrieben.
- Fig. 1: zeigt eine bekannte Querschnittsstruktur eines planaren Transformators, integriert in einem dielektrischen Schaltungsträger, ausgeführt als sogenannte Kernstruktur mit den Schaltungsträger durch-dringenden Ferrit-Elementen,
- Fig. 2: zeigt eine bekannte Querschnittsstruktur eines planaren Transformators, integriert in einem die-lektrischen Schaltungsträger, wobei die Ferrit-Elemente in Form von Ferritplatten beidseitig des Schaltungsträgers im Bereich des Transformators anliegen,
- Fig. 3: zeigt im Querschnitt die Komponenten eines mit SMD-Bauelementen bestückten planaren Transformators mit beidseitig isolierten, gesinterten Ferritplatten,
- Fig. 4: zeigt eine Darstellung der Transformatorstruktur nach Abschluss der aufbau- und verbindungstechnischen Prozessschritte entsprechend Fig. 3.

Im Folgenden wird insbesondere als Variante eines planaren, induktiven Bauelementes ein planarer Transformator betrachtet. Entsprechend der vorliegenden Erfindung besteht, wie in Fig. 3 dargestellt, der planare Transformator zunächst dem Stand der Technik entsprechend aus einer primären und einer sekundären Wicklung 21 und 22 von Leiterbahnen, die in einen mehrlagigen Schaltungsträger 1 eingebettet sind. Als Träger einer ausgedehnteren Schaltung besitzt die Platine 1 zusätzliche oberflächliche Metallisierungslagen 111 bis 118 sowie eingebettete Metallisierungslagen 121, 122. Die oberflächlichen und die eingebetteten Lagen sind mit Hilfe metallischer Durchkontaktierung 131 bis 134 elektrisch leitfähig verbunden. Der Transformator wird beidseitig mit Ferritplatten 311, 321 ausgestattet. Über den Stand der Technik hinausgehend werden diese Ferritplatten aus niedrig sinternder LTCC-Keramik hergestellt, beispielsweise aus MnZn-Ferrit oder NiZnCu-Ferrit. Es besteht die Möglichkeit, ein- oder mehrlagige Ferritplatten darzustellen. Durch Nutzung der keramischen Mehrlagentechnik können die Ferritplatten mit dielektrischen, isolierenden Deckschichten 312, 313 bzw. 322, 323 und zusätzlich mit Durchkontaktierungen 3111, 3112 bzw. 3211, 3212 sowie Leiterbahnen 3121 bis 3134 bzw. 3221 bis 3234 versehen werden. Sie besitzen damit die Merkmale eigenständiger Schaltungsträger 31 bzw. 32 (Ferritplatinen). Wesentlich ist für die Erzielung ausreichender Isolation zwischen den oberflächlichen Kontaktflächen, beispielsweise 3222 und 3223 die Aufbringung der dielektrischen Isolatorschichten 312, 313 bzw. 322, 323, die vorzugsweise aus einem keramischen Material bestehen. Eine Ferritplatte ist zumindest einseitig, vorzugsweise jedoch beidseitig in einem Sinterverfahren mit derartigen dielektrischen Isolatorschichten versehen und bildet damit ein Element, welches auf den eigentlichen ein- oder mehrlagigen Schaltungsträger 1, die Platine, mittels Löt- oder Klebeverbindungen 411 bis 414 bzw. 421 bis 424 so angebracht wird, dass neben der mechanischen Befestigung an den Kontaktflächen auch eine elektrisch leitfähige Verbindung zwischen der jeweiligen Ferritplatine und der Hauptplatine entsteht. Diese Aufbringung von in Temperatur belastenden Verfahren hergestellten beschichteten Ferritplatten geschieht vorzugsweise beiderseits des dielektrischen Schaltungsträgers 1.

Damit wird eine elektrisch isolierte Oberfläche mit strukturierten Leiterbahnen auf der ansonsten halbleitenden Ferritkeramik der Ferritplatten realisiert, die Bestandteil des gesamten Schaltungslayouts ist und somit platzsparend mit SMD-Elementen 511 bis 523 bestückt werden kann. Die Lagen des ein- oder mehrlagigen dielektrischen Schaltungsträgers 1 können beispielsweise aus organischem oder keramischen Material oder aus einem Verbundmaterial bestehen.

Die Verbindungstechnik 41, 42, mit der die Ferritplatten 31, 32 auf dem dielektrischen Schaltungsträger 1 befestigt werden, muss mechanischen, elektrischen und thermischen Anforderungen genügen. Entsprechend sind Klebstoffe wie Epoxid-Kleber oder Lote wie Hartlot oder nano-technologisches Silberlot vorteilhaft einsetzbar. Durch die im Rahmen der LTCC-Technolgie erzielbare Isolation der Ferritplatten mit Hilfe einer oder mehrerer dielektrischer Isolatorschichten 312, 313, 322, 323, insbesondere bestehend aus dielektrischer Keramik, sowie die gleichzeitig einbrennbare Oberflächenmetallisierung 3121 bis 3234, wird eine bestückbare und einfach kontaktierbare Oberfläche des Transformators erzielt.

Alternativ zu den elektrischen Durchkontaktierungen 3111, 3112 bzw. 3211, 3212 innnerhalb der Ferritplatinen kann die Oberflächenmetallisierung 111 bis 118 auf der Hauptplatine auch mit Hilfe von Bonddrähten mit derjenigen auf den Ferritplatinen verbunden werden.

In der LTCC-Technologie werden zunächst einzelne Grünfolien verarbeitet. Für die meist vertikalen Durchkontaktierungen werden mit Hilfe von Lasern oder mechanischen Stanzwerkzeugen Öffnungen in die Folie eingebracht, wobei eine Auffüllung mittels Schablonendruck mit leitfähiger Metallpaste geschieht. Planare Leitungsstrukturen werden auf der Folienoberfläche durch Siebdruck hergestellt und anschließend werden typischer Weise zehn bis zwanzig Folien aufeinander laminiert und gesintert. Damit wird ein hermetisch dichter mehrlagiger Schaltungsträger dargestellt.

Bei ausschließlicher Verwendung von hoch temperaturstabiler Aufbau- und Verbindungstechnik wie z.B. Hartlöten oder Drahtbonden in Verbindung mit anorganischen, keramischen Mehrlagenplatinen wird der thermische Einsatzbereich der Schaltung bis zur Curietemperatur des Ferritmaterials erweitert, welche typischer Weise bei 250°Celsius liegt.

Durch Weiterentwicklung der Ferritplatten zu bestückbaren Ferritplatinen wird die sonst unbrauchbare Fläche des Transformators bzw. der Spule für die Bestückung mit oberflächenmontierbaren Bauelementen/ SMD im niederfrequenten Bereich nutzbar. Dadurch kann an anderer Stelle Platinenfläche eingespart werden und die gesamte Schaltung kann verkleinert werden.

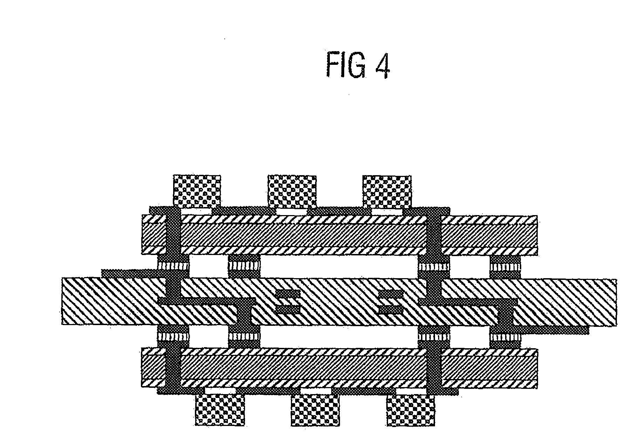

Der in den Fig. 1 und 2 dargestellte Stand der Technik teilt sich in eine Kernstruktur entsprechend Fig. 1 und in eine Plattenstruktur entsprechend Fig. 2. Die Basis für die Weiterentwicklung zur Darstellung der Erfindung ist die Plattenstruktur. Sie hat sich durch prozesstechnische Vereinfachung für Anwendungen bei höherer Frequenz (MHz) aus der früheren, niederfrequenter betriebenen (100kHz) Kernstruktur nach Fig. 1 entwickelt. Die in Fig. 2 dargestellten Ferritplatten 2 werden im Bereich eines Transformators mit den Spulen 8 beiderseits eines dielektrischen Schaltungsträgers 1 platziert. Entsprechend Fig. 3 und Fig. 4 stellt sich eine Schaltungsanordnung entsprechend der Erfindung wie folgt dar: Auf der Basis eines mindestens eine planare Spule 21, 22 enthaltenden ein- oder mehrlagigen dielektrischen Schaltungsträgers 1, beispielsweise einer Platine aus Keramik oder Epoxidharz, werden die Ferritplatinen 31, 32 beidseitig zum dielektrischen Schaltungsträger 1 im Bereich der Spule bzw. eines planaren Transformators angebracht. Die Ferritplatinen 31, 32 werden mit Löt- oder Klebeverfahren 41, 42 auf dem dielektrischen Schaltungsträger 1 befestigt. In einer Vorstufe dazu werden die Ferritplatten 311, 321 als Mehrschichtkörper aus einzelnen ferritischen Grünfolien aufgebaut und durch Thermokompression mit isolierenden dielektrischen Grünfolien 312, 313, 322, 323 zu einem Verbundkörper 31, 32 laminiert. Die Grünfolien werden vor dem Laminieren einzeln mit ausgestanzten und leitfähig verfüllten Durchkontaktierungen sowie siebgedruckter Oberflächenmetallisierung versehen. Die Verbundkörper 31, 32 werden einzeln bei niedriger Sintertemperatur von beispielsweise 900°Celsius gebrannt. Dies gelingt spannungs- und rissfrei auf Basis wechselseitig angepassten Sinter- und Wärmeausdehnungsverhaltens der Metallpasten und der ferritischen bzw. dielektrischen Folien.

Oberflächenmontierbare Bauelemente 511 bis 523 können auf dem dielektrischen Schaltungsträger 1 und, was wesentlich ist, auch auf den Ferritplatinen 31, 32 montiert werden. Elektrische Anschlüsse können mit Hilfe der Durchkontaktierungen 3111 bis 3212 über die leitfähigen Verbindungselemente 41, 42 aus der Oberflächenmetallisierung 111 bis 118 der Hauptplatine 1 erfolgen.

Figur 4 zeigt die in Figur 3 dargestellten Teile im zusammen gebauten Zustand. Die Bezugszeichen sind der Figur 3 zu entnehmen.

Die Prozesstemperatur in der LTCC-Technologie bzw. die Sintertemperatur beträgt ca. 900°Celsius. In Zusammenhang mit dieser Technologie können Materialien wie Silber günstig verarbeitet werden. Möglich ist auch der Einsatz der sogenannten HTCC-Technologie/ High Temperature Cofired Ceramics, wobei Molybdän, Wolfram und Platin als Leiter eingesetzt werden. Der prinzipielle Schaltungsaufbau geschieht in der gleichen Weise wie bei LTCC-Technologie/ Low Temperature Cofired Ceramics.

### Literaturverzeichnis

[1] SATO T, YOKOYAMA H, YAMASAWA K, TOYA K, KOBAYASHI S, MI-NAMISAWA T: "Multilayered transformer utilizing Mn-Zn ferrite and its application to a forward-type DC-DC converter." Electrical Engineering in Japan 2001; 135;1-8
[2] WAFFENSCHMIDT E, JACOBS J: "Planar resonant multi-output transformer for printed circuit board integration. Proceedings of the 39th Annual Power Electronics Specialists Conference (PESC) 2008: 4222-4228

## Patentansprüche

1. Mehrlagige Schaltungsanordnung bestehend aus:
mindestens einem dielektrischen ein- oder mehrlagigen Schaltungsträger (1) mit mindestens einer integrierten planaren Spule und/oder mindestens einem integrierten planaren Transformator (21, 22), sowie auf dem mindestens einen dielektrischen Schaltungsträger (1), gegenüberliegend im Bereich einer Spule und/oder eines Transformators angeordneten Ferritplatinen (31, 32)
**dadurch gekennzeichnet, dass**
- Ferritplatten (311, 321) beidseitig zumindest partiell mit mindestens einer dielektrischen, keramischen, gesinterten Isolatorschicht (312, 313, 322, 323) bedeckt sind,
- der dielektrische Schaltungsträger (1) mit einer Oberflächenmetallisierung (111 bis 118) versehen ist, und
- wobei die beschichteten Ferritplatinen (31, 32) jeweils auf der Oberfläche des dielektrischen Schaltungsträgers (1) fest aufgebracht sind und nach außen eine Fläche zur Bestückung mit oberflächenmontierbaren Bauelementen darstellen.

2. Schaltungsanordnung nach Anspruch 1,
**dadurch gekennzeichnet, dass** die Ferritplatten (31, 32) aus ein- oder mehrlagiger, bei niedriger Temperatur gesinterter Keramik/ LTCC bestehen.

3. Schaltungsanordnungen nach Anspruch 2,
**dadurch gekennzeichnet, dass** Ferritplatten ein MnZn-Ferrit oder ein NiZnCu-Ferrit enthalten.

4. Schaltungsanordnung nach einem der vorher ergehenden Ansprüche,
**dadurch gekennzeichnet, dass** der dielektrische Schaltungsträger (1) aus organischem, keramischem oder Verbund-Material besteht.

5. Schaltungsanordnung nach einem der vorher ergehenden Ansprüche,
**dadurch gekennzeichnet, dass** die Befestigung der Ferritplatinen (31, 32) an der Oberfläche des dielektrischen Schaltungsträgers (1) als Klebung oder als Lotverbindung ausgeführt ist.

6. Schaltungsanordnung nach Anspruch 5,
**dadurch gekennzeichnet, dass** eine Lotverbindung mit nanotechnologischem Silberlot ausgeführt ist.

7. Schaltungsanordnung nach einem der vorher ergehenden Ansprüche,
**dadurch gekennzeichnet, dass** der Schaltungsträger (1) und die Ferritplatinen (31,32) aus mehreren Lagen mit oberflächlichen (111 bis 118, 3121 bis 3134, 3221 bis 3234) und eingebetteten (121, 122) Leiterbahnen sowie Durchkontaktierungen (131 bis 134, 3111, 3112, 3211, 3212) bestehen, die untereinander verbindbar sind.

8. Schaltungsanordnung nach einem der vorher ergehenden Ansprüche,
**dadurch gekennzeichnet, dass** elektrische Verbindungen zwischen dem Schaltungsträger (1) und den Ferritplatinen (31, 32) mittels Drahtbonden ausgeführt sind.

9. Schaltungsanordnung nach einem der vorher ergehenden Ansprüche,
**dadurch gekennzeichnet, dass** elektrische Verbindungen zwischen dem Schaltungsträger (1) und den Ferritplatinen (31, 32) jeweils mittels einer auflaminierten organischen Folie ausgeführt werden, wobei die Folien durch Laserbearbeitung an den gewünschten Kontaktstellen geöffnet sind und dort durch photolithographische Strukturierung und galvanische Prozesstechnik eine weitere Metallisierungsebene ergänzt ist.

10. Schaltungsanordnung nach einem der vorher ergehenden Ansprüche,
**dadurch gekennzeichnet, dass** oberflächenmontierbare/ SMD-Bauelemente (511 bis 523) aufgebracht sind.

11. Verfahren zur Herstellung einer mehrlagigen Schaltungsanordnung entsprechend einem der Ansprüche 1 bis 10,
**dadurch gekennzeichnet, dass**
- Ferritplatten (311, 321) vor der Befestigung auf einem dielektrischen Schaltungsträger (1) extern bei niedriger Temperatur aus einer LTCC-Keramik mittels eines Sinterverfahrens hergestellt werden, mindestens einlagig ausgebildet sind und jeweils beidseitig mit einer dielektrischen Isolatorschicht (312, 313. 322, 323) mittels eines Sinterverfahrens beschichtet werden,
- Auf den Ferritplatten (311, 321) eine einbrennbare Oberflächenmetallisierung (3121 bis 3134, 3221 bis 3234) aufgebracht wird,
- fertig gesinterte und mit Isolatorschichten (312, 313. 322, 323) versehene Ferritplatinen (31, 32) mittels eines Klebe- oder Lötverfahrens auf dem dielektrischen Schaltungsträger (1) befestigt werden.

12. Verfahren nach Anspruch 11,
**dadurch gekennzeichnet, dass** auf Oberflächen dielektrischer Schichten Leiterbahnen durch Siebdruck dargestellt werden.

## Claims

1. Multi-layer circuit arrangement comprising:
at least one dielectric single- or multi-layer circuit carrier (1) having at least one integrated planar coil and/or at least one integrated planar transformer (21, 22), and ferrite circuit boards (31, 32) arranged on the at least one dielectric circuit carrier (1), lying opposite in the region of a coil and/or a transformer,
**characterized in that**
- ferrite boards (311, 321) are covered on both sides at least partially by at least one dielectric, ceramic, sintered isolation layer (312, 313, 322, 323),
- the dielectric circuit carrier (1) is provided with a surface metallization (111 to 118), and
- wherein the coated ferrite circuit boards (31, 32) are each securely attached to the surface of the dielectric circuit carrier (1) and externally represent a surface for populating with surface-mountable components.

2. Circuit arrangement according to claim 1,
**characterized in that** the ferrite boards (311, 321) consist of single- or multi-layer ceramic/LTCC sintered at low temperature.

3. Circuit arrangement according to claim 2,
**characterized in that** ferrite boards contain an MnZn ferrite or an NiZnCu ferrite.

4. Circuit arrangement according to one of the preceding claims,
**characterized in that** the dielectric circuit carrier (1) consists of organic, ceramic or composite material.

5. Circuit arrangement according to one of the preceding claims,
**characterized in that** the attachment of the ferrite circuit boards (31, 32) to the surface of the dielectric circuit carrier (1) is in the form of adhesive bonding or a soldered connection.

6. Circuit arrangement according to claim 5,
**characterized in that** a soldered connection is made with nanotechnological silver solder.

7. Circuit arrangement according to one of the preceding claims,
**characterized in that** the circuit carrier (1) and the ferrite circuit boards (31, 32) consist of multiple layers with superficial (111 to 118, 3121 to 3134, 3221 to 3234) and embedded (121, 122) conductor tracks and contact vias (131 to 134, 3111, 3112, 3211, 3212), which can be connected to one another.

8. Circuit arrangement according to one of the preceding claims,
**characterized in that** electrical connections between the circuit carrier (1) and the ferrite circuit boards (31, 32) are made by means of wire bonding.

9. Circuit arrangement according to one of the preceding claims,
**characterized in that** electrical connections between the circuit carrier (1) and the ferrite circuit boards (31, 32) are respectively made by means of a laminated-on organic film, the films being opened at the desired contact points by laser machining and a further metallization level being added there by photolithographic patterning and a galvanic process technique.

10. Circuit arrangement according to one of the preceding claims,
**characterized in that** surface-mountable/SMD components (511 to 523) are attached.

11. Method for producing a multi-layer circuit arrangement corresponding to one of claims 1 to 10,
**characterized in that**
- ferrite boards (311, 321) are produced by means of a sintering method externally at a low temperature from an LTCC ceramic before being attached to a dielectric circuit carrier (1), are formed in at least one layer and are each coated on both sides by a dielectric isolation layer (312, 313, 322, 323) by means of a sintering method,
- a surface metallization (3121 to 3134, 3221 to 3234) that can be burned in is applied to the ferrite boards (311, 321),
- finished-sintered ferrite circuit boards (31, 32) provided with isolation layers (312, 313, 322, 323) are attached to the dielectric circuit carrier (1) by means of an adhesive-bonding or soldering method.

12. Method according to claim 11,
**characterized in that** conductor tracks are represented on surfaces of dielectric layers by screen printing.

## Revendications

1. Agencement de circuit multicouche constitué par :
au moins un support de circuit diélectrique mono ou multicouche (1) avec au moins une bobine plane intégrée et/ou au moins un transformateur plan intégré (21, 22), ainsi que des plaques de ferrite (31, 32) placées sur ledit au moins un support de circuit diélectrique (1) en regard l'une de l'autre au niveau d'une bobine et/ou d'un transformateur,
**caractérisé en ce que**
- des plaques de ferrite (311, 321) sont recouvertes sur les deux faces au moins partiellement par au moins une couche d'isolant diélectrique céramique frittée (312, 313, 322, 323),
- le support de circuit diélectrique (1) est pourvu d'une métallisation de surface (111 à 118), et
- les plaques de ferrite revêtues (31, 32) étant chacune appliquées solidement sur la surface du support de circuit diélectrique (1) et constituant vers l'extérieur une surface destinée à être équipée de composants pour montage en surface.

2. Agencement de circuit selon la revendication 1,
**caractérisé en ce que** les plaques de ferrite (31, 32) sont réalisées en céramique mono ou multicouche frittée à basse température (LTCC).

3. Agencement de circuit selon la revendication 2,
**caractérisé en ce que** des plaques de ferrite contiennent un ferrite de MnZn ou un ferrite de NiZnCu.

4. Agencement de circuit selon l'une des revendications précédentes,
**caractérisé en ce que** le support de circuit diélectrique (1) est réalisé en matériau organique, céramique ou composite.

5. Agencement de circuit selon l'une des revendications précédentes,
**caractérisé en ce que** la fixation des plaques de ferrite (31, 32) sur la surface du support de circuit diélectrique (1) est réalisée sous forme de collage ou sous forme de brasage.

6. Agencement de circuit selon la revendication 5,
**caractérisé en ce qu'**un brasage est réalisé avec du métal d'apport nanotechnologique à base d'argent.

7. Agencement de circuit selon l'une des revendications précédentes,
**caractérisé en ce que** le support de circuit diélectrique (1) et les plaques de ferrite (31, 32) sont constituées de plusieurs couches avec des pistes conductrices superficielles (111 à 118, 3121 à 3134, 3221 à 3234) et noyées (121, 122) ainsi que des trous métallisés (131 à 134, 3111, 3112, 3211, 3212), qui peuvent être connectées entre elles.

8. Agencement de circuit selon l'une des revendications précédentes,
**caractérisé en ce que** des connexions électriques entre le support de circuit (1) et les plaques de ferrite (31, 32) sont réalisées par métallisation de fils.

9. Agencement de circuit selon l'une des revendications précédentes,
**caractérisé en ce que** des connexions électriques entre le support de circuit (1) et les plaques de ferrite (31, 32) sont réalisées chacune au moyen d'une feuille organique déposée sous forme de couche, les feuilles étant ouvertes aux points de contacts souhaités par usinage au laser et un autre plan de métallisation étant complété à cet endroit par une structuration photolithographique et une technique de procédé galvanique.

10. Agencement de circuit selon l'une des revendications précédentes,
**caractérisé en ce que** des composants pour montage en surface (SMD)(511 à 523) sont déposés.

11. Procédé de fabrication d'un agencement de circuit multicouche selon l'une des revendications 1 à 10,
**caractérisé en ce que**
- des plaques de ferrite (311, 321) sont fabriquées à l'extérieur à basse température à partir d'une céramique LTCC au moyen d'un procédé de frittage avant la fixation sur un support de circuit diélectrique (1), sont formées d'au moins une couche et sont revêtues sur les deux faces d'une couche d'isolant diélectrique (312, 313, 322, 323) au moyen d'un procédé de frittage,
- sur les plaques de ferrite (311, 321) est déposée une métallisation de surface (3121 à 3134, 3221 à 3234) susceptible d'être cuite,
- les plaques de ferrite (31, 32) frittées à l'état fini et pourvues de couches d'isolant (312, 313, 322, 323) sont fixées sur le support de circuit diélectrique (1) au moyen d'un procédé de collage ou de brasage.

12. Procédé selon la revendication 11,
**caractérisé en ce que** des pistes conductrices sont réalisées par sérigraphie sur des surfaces de couches diélectriques.
